# EUROPEAN PATENT SPECIFICATION

(11) **EP 2 347 305 B1**
(45) Date of publication and mention of the grant of the patent: **04.05.2016**
(21) Application number: 09747820.0
(22) Date of filing: 02.11.2009
(51) Int. Cl.: G03F 7/20

(54) **A METHOD AND INSTALLATION FOR WRITING LARGE GRATINGS**
VERFAHREN UND INSTALLATION ZUR ABBILDUNG GROSSER GITTER
PROCÉDÉ ET INSTALLATION D'IMPRESSION DE GRANDS RÉSEAUX

(30) Priority: 03.11.2008 EP 08291024
(43) Date of publication of application: 27.07.2011
(73) Proprietor: Parriaux, Olivier, 1005 Lausanne (CH)
(72) Inventor: JOURLIN, Yves, F-42000 Saint-Etienne (FR); PARRIAUX, Olivier, CH-1005 Lausanne (CH)
(74) Representative: Surmely, Gérard
(86) International application number: PCT/EP2009/064445
(87) International publication number: WO 2010/060741

(56) References cited:
- EP-A- 1 443 361
- JP-A- 2007 073 546
- US-A1- 2008 206 685
- US-B1- 6 882 477
- GAMET ET AL: "Flying phase mask for the printing of long submicron-period stitchingless gratings" MICROELECTRONIC ENGINEERING, ELSEVIER PUBLISHERS BV., AMSTERDAM, NL, vol. 83, no. 4-9, 1 April 2006 (2006-04-01), pages 734-737, XP005426690 ISSN: 0167-9317 cited in the application

## Description

### Field of the invention

The present invention concerns the photolithographic writing of wide gratings of high spatial coherence by means of a phase mask.

### Background of the invention

There is an increasing need for large area gratings in different scientific domains and business fields. For instance, the femtosecond pulse compression gratings of the future utmost energy chirped pulse amplification installations require ever larger grating areas to sustain the desired fluence. The current grating area today is one quarter of a square meter and laboratories heading the race to ever higher energies need high spatial coherence gratings of about two square meters which can only be made by tiling two one square meter gratings. The investments required to fabricate large gratings with standard methods increase much faster than linearly with the grating area. In particular, the lithography step is mainly responsible for this cost increase. There is therefore a strong need for a method and related processes for writing high spatial coherence large size gratings which necessitate equipments and infrastructure whose cost increases at a significantly lower rate with the grating area.

Large size gratings are not only needed in high-end domains such as pulse compression, but also in business domains concerned with mass production such as in flat displays and intelligent windows where some white light processing functions using diffraction gratings would advantageously be performed monolithically at the substrate surface. An example is the wide band quasi-lossless wire grid polarizer for liquid crystal displays which requires a large area grating of about 100 nanometer period. Although the spatial coherence requirements on such mass produced gratings are not as critical as in high-end scientific applications, it is necessary to avoid any field stitching and non-uniformities of groove depth and line/space ratio because the eye is very sensitive to phase errors and non-uniformities. High uniformity of line/space ratio and of groove depth is also required in high-end applications since these geometrical parameters determine the diffraction efficiency of the desired diffraction order(s).

The technology of LCDs has faced the problem of large scale lithography since its beginning and has always had to design specific solutions to photoprint patterns significantly larger than their contemporary microelectronic counterparts, but with a larger characteristic dimension. Exposure methods and apparatus have been disclosed to reduce the price and handling difficulties of a single mask having the dimensions of the LCD; these methods resort to the two-dimension spatial multiplexing of parallel exposure units as well as to a one dimension scanning for the high productivity of the different types of features in the driving electronic circuits of LCDs. So does document US 2008/0206685 A1 which uses a plurality of small spatially multiplexed, mechanically replaceable double-grating phase masks for the printing of the periodic electrical signal lines and standard mask features for the definition of the transistors. The scanned printing of the periodic lines is performed in a direction parallel to the lines. The method and apparatus of US 2008/0206685 A1 can not be extended for the printing of large size, uniform, highly coherent gratings of micron or submicron period because the spatial multiplexing of a number of exposure units, each with its phase mask would lead to stitching errors, grating line orientation errors without real time correction means, and to exposure light dose non-uniformities.

Document EP 1 443 361 A2 also aims at printing simultaneously periodic signal lines and discrete circuit elements of a LCD upon a single scan in a direction parallel to the lines. It uses a double amplitude mask containing reflective and transmissive patterns which an imaging system projects onto a resist-coated substrate in the form of an image line essentially normal to the scan direction. The disclosed apparatus could print a large grating, however, the spatial frequency and the spatial coherence would be limited by the amplitude mask technology and related imaging lithography scheme respectively.

The document of Schattenburg, MIT, US Patent No 6,882,477, describes the fabrication of large gratings by the two-dimensional scanning on a photosensitive surface of an elementary small area interferogram produced by the overlap of two coherent interfering Gaussian beams. It also describes an embodiment where the elementary interferogram is created by a phase mask placed next to the photosensitive surface. A drawback of the described phase mask embodiment is that the relative displacement between the phase mask and the photosensitised surface is made by stepping and repeating neighbouring printed fields which implies successive positive and negative accelerations in both directions of the plane with adverse consequences on the stitching between adjacent fields and on the uniformity of the delivered photon dose. The major drawback of the writing method described by this document is that the relative position of the phase mask and of the substrate must be controlled very accurately within a few nanometers along X and Y as well as angularly within the X-Y plane so that the stitching between fields and between all lines of two adjacent fields is made with an exactness within a small fraction of the period of the transferred grating, and so that the lines of the resulting large grating are strictly rectilinear and parallel. A further drawback is that the method of step and repeat of neighbouring fields leads to a non-uniformity of the dose which can only be approximately smoothed by means of fine overwriting obtained by multiple exposures which multiplies the number of mechanical scans and increases the probability of errors on the spatial coherence.

The paper of E. Gamet & al. "Flying phase mask for the printing of long submicron-period stitchingless gratings" (Reference [1]) also demonstrates the use of a small flying interferogram for the writing of a long grating track. It describes a method for the writing of a long and narrow grating track by means of a phase mask of small dimension under continuous displacement illuminated by a spatially filtered Gaussian exposure light beam whose power is amplitude modulated in synchronism with the spatial frequency assigned to the fabricated grating under the control of a high accuracy displacement sensor. This grating writing method permits to smooth the mechanical displacement along the writing direction normal to the grating lines. Using such a writing method of long and narrow grating tracks for obtaining a wider grating would require the writing of a plurality of parallel grating tracks with a corresponding plurality of successive grating scans along an X direction. However, the incremental displacement in the orthogonal Y direction (parallel to the grating lines), required for the overwriting of successive grating scans along X to obtain a uniform dose along Y or for the exact stitching between adjacent grating scans along X of top-hat dose profile, must be made strictly orthogonally to the X displacement. Like in document US 6,882,477, this will be possible only under a very precise control of the position of the phase mask relative to the grating under fabrication as well as of the angle of the lines of the phase mask in the X-Y plane to avoid stitching errors between lines. Such a control is needed to prevent a loss of contrast and a possible washing out of the latent grating in the photoresist layer due to the overlap of adjacent grating scans and, more generally, to avoid any alteration of the spatial frequency spectrum of the final grating.

Document JP 2007-73546 discloses exposure method and equipment for the printing of fine lines using a collimated light beam impinging normally on a phase mask. Like document US 2008/0206685 it uses a double-grating, double-substrate phase mask to create a periodic interferogram. Like document US 6,882,477 it lends itself to a two-dimension scanning although the use of a phase mask permits the interferogram to be significantly larger than that of document US 6,882,477. The use of such method and equipment for the writing of highly coherent and uniform gratings beyond the 300 mm size faces the same difficulties as document US 6,882,477 for the in-plane position control with the additional difficulty of the relative position and orientation control between the two separate gratings composing the phase mask. It also discloses a trapeze-shaped phase mask permitting a better dose uniformity upon a step and repeat scan along the direction of the grating lines.

Referring to documents US 2008/0206685, JP 2007-73546 and EP 1 443 361, those skilled in the art who wish to expand the length of a phase mask having its lines in the direction of the scan in order to write a wide grating of high spatial coherence in a single scan do not face big additional mechanical difficulties since the main control parameter is the rectilinearity of the scan, i.e., the constancy of the coordinate Y upon a scan along X and since the yaw between the phase mask grating K-vector and the displacement direction is a second order effect. This lateral control is the same for a short and for a long phase mask. Would those skilled in the art make a one-dimension scan of a long phase mask having its lines perpendicular to the scan direction with any of the opto-mechanical systems described in the 3 above-mentioned documents, the wide latent grating that it would print would be partially or totally washed out because of the occurrence of yaw (though small the latter may be) even though they would use the synchronous modulation of the paper of Gamet & al. A disadvantage of the single scan of a long length phase mask with its lines in the direction of the scan is that it requires a plane wave front quality over a large length (thus over large area) which only a highly sophisticated exposure system, for instance of the type disclosed in document JP 2007-73547, could provide for the printing of a high spatial coherence grating since the local direction of the fringes of the interferogram depends on the local incidence angle, i.e., on the local wave front slope. This can be achieved as JP 2007-73547 does, but the cost of the beam conditioning system involving a plurality of elements increases much more than linearly with the exposed area because of the demands on the wave spatial coherence.

### Summary of the invention

There is a need to replace the state of the art real time, local control of all opto-geometrical parameters of a limited size interferogram by a method and apparatus whereby essential spatial coherence features of the grating to be printed are embarked onto a monolithic phase mask, and whereby the substrate scanning relative to the phase mask only requires the control of the minimum number of relative displacement parameters necessary to ensure and preserve the spatial coherence and uniformity of the printed grating.

Thus, the present invention concerns an installation for writing gratings comprising :
- a basis,
- a platform arranged for receiving a substrate covered by a photosensitive layer,
- a phase mask having lines defining at least a grating, this phase mask being supported by a bridge,
- a light source associated with means for projecting an exposure beam on said phase mask which diffracts said exposure beam to form an interferogram in said photosensitive layer so as to define in this photosensitive layer a latent grating having a determined period A;
said platform and said bridge being mounted on said basis so that a relative translation movement can occur between them, said platform or said bridge defining a moving part associated with guiding means along a translation axis;
wherein said phase mask has a length L_{Y}, along an orthogonal axis (Y) relative to said translation axis (X), which is greater than hundred millimetres (100 mm), the lines of this phase mask being parallel to said orthogonal axis, in that this installation comprises sensor means for detecting, during said relative translation movement, a possible yaw between said phase mask and said substrate and further comprises a tilt actuator controlled in function of the detection of said possible yaw and arranged for varying the orientation of said phase mask relatively to said substrate in order to limit said possible yaw under a maximum value equal to A/(5L_{Y}), and in that said exposure beam is formed by a light sheet having its general plane parallel to the lines of said phase mask.

According to a preferred embodiment, the light sheet is divergent in its general plane and substantially collimated normally to its general plane.

In particular, the length L_{Y} of said phase mask is superior to three hundred millimetres (300 mm).

The present invention allows the writing of gratings of large dimensions and of high spatial coherence by means of a relatively simple low cost mechanics, control instrumentation and light exposure means. The solution resides in the transfer of essential requirements on the relative position between the phase mask and the grating under fabrication onto the phase mask itself. Whereas the methods described by the prior art require either a highly controlled scan along X of a mask having its lines along X and a perfectly collimated exposure beam of large cross-section or a very large number of high accuracy scans along X and Y, a real time control at nanometer accuracy of the X and Y coordinates as well as of the orientation of the lines of the interferogram (i.e. of the phase mask grating), the writing method of the present invention writes a high spatial coherence, possibly very large grating by a single continuous and transversally uniform exposure scan in a single direction by using sensor means detecting a possible yaw of the phase mask and a tilt actuator controlled by these sensor means. Further it only involves one continuous relative translation between the substrate of the grating under fabrication and the phase mask along the translation axis. Thus, the control of the position of the phase mask relative to the substrate of the grating under fabrication only applies to the translation position and to the fine adjustment of the orientation of the phase mask grating lines in a narrow angular neighbourhood of the direction orthogonal to the translation direction.

The installation of the invention permits the exposure of a long phase mask having its lines perpendicular to the scan direction by illumination means which are extremely simple, low cost and whose cost practically does not increase with the length of the phase mask, i.e., with the width of the large printed grating. The illumination means can be an optical element producing a plane light sheet from a laser beam, this light sheet having a divergence in its general plane. With such divergent exposure light sheet, created by very simple means, use can be made of the property of a phase mask under such exposure condition of producing the same interferogram period regardless of the incidence angle in the plane of the light sheet. Thus the combination of a scan with phase mask lines transverse to the scanning direction permits to define an exposure system of great simplicity, low weight, high stability whose cost is essentially independent of the length of the phase mask, i.e., of the width of the large grating under writing. The washing out of the latent grating upon the scan orthogonal to the phase mask grating lines is prevented by using the synchronous modulation scheme of the article by Gamet & al. and by a tight control of the yaw upon the scan.

### Brief description of the figures

- Figure 1 is the top view of an embodiment of the grating writing installation according to the invention;
- Figures 2 a and 2 b are respectively the side view of the phase mask in normal incidence configuration and in Littrow configuration;
- Figures 3 a), 3 b), and 3 c) are respectively the top view, side view and front view of the exposure configuration in the installation of Figure 1.

### Detailed description

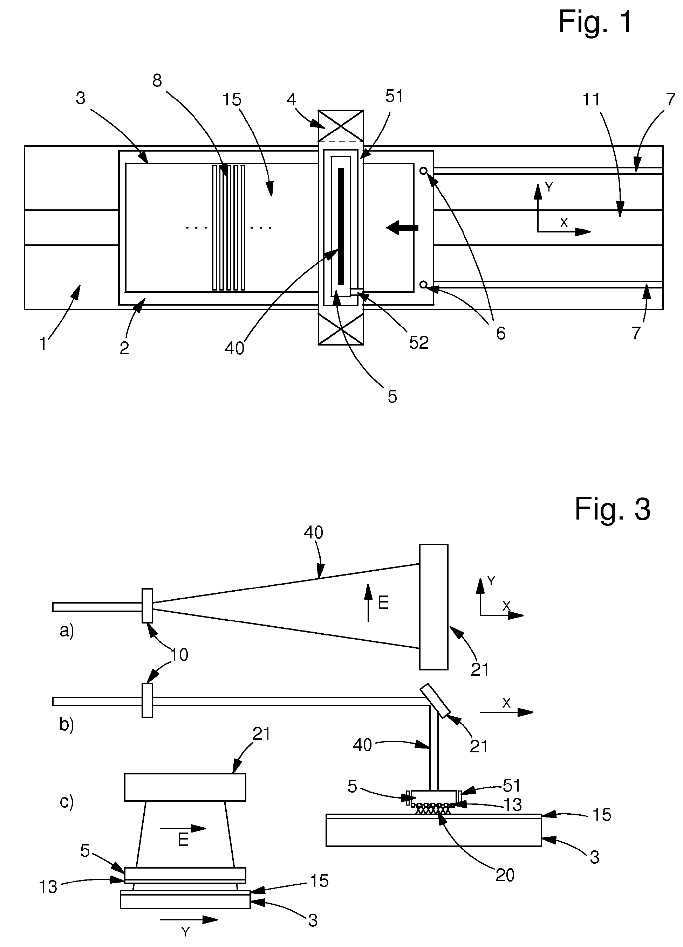

Figures 1 and 3 schematically show the installation of the invention. This installation for writing large gratings comprises a basis 1 and a platform 2 which can move along the X axis of the basis 1. Mechanical guiding means 11 are provided to precisely guide the platform in its translation movement along X. Guiding means 11 ensure the needed smooth and straight translation; it is based on air or oil bearings. An essentially plane substrate 3 rests on the moving platform 2. Substrate 3 has a photosensitive coating 15 at its surface. The translation of platform 2 on basis 1 along X is controlled by high resolution sensor(s) measuring the displacement along X and the yaw. Such sensor can for instance be a triple beam plane mirror interferometer from SIOS GmbH measuring the yaw at better than 0.02 arcsec resolution. In Figure 1, the displacement along X and the yaw are measured by two identical displacement sensors comprising a grating scale 7 fixed to basis 1 and a read head 6 fixed to platform 2. Platform 2 translates under a fixed mechanical bridge 4. Bridge 4 is rigidly attached to basis 1. Bridge 4 supports the phase mask 5 in its frame 51. The frame 51 is suspended in bridge 4 by means of a monolithic mechanics according to Reference [2] allowing a small tilt movement in the X-Y plane. In the presence of yaw detected by the sensor means, frame 51 is actuated by a tilt actuator 52 which keeps the direction of the lines of the phase mask grating parallel to themselves during the scan along X. Such high resolution actuator can be a piezo-actuator of Piezojena GmbH or of Physik Instruments which can achieve nanometer resolution with negligible hysteresis. The characterization of the translation characteristics (yaw, straightness deviations, Reference [3]) can be performed by metrological offices, such as OFMET (Switzerland, Reference [4]), PTB (Germany), LNE (France) or NPL (UK).

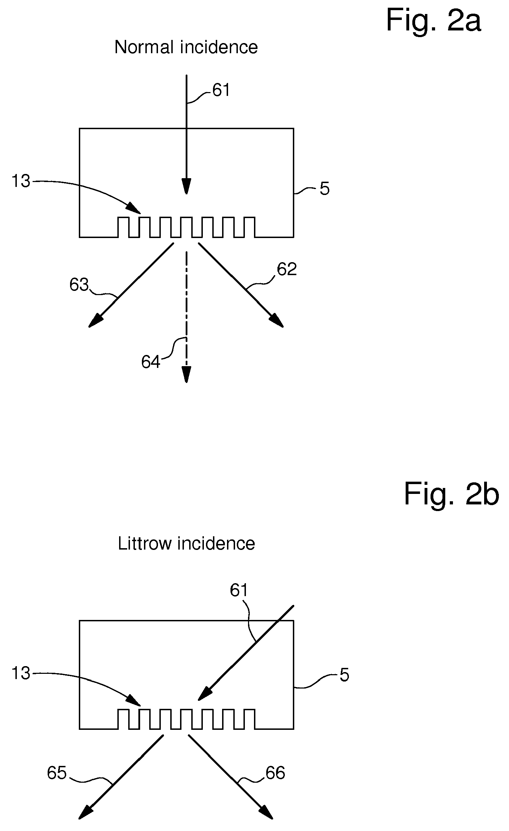

The grating 13 of phase mask 5 is illuminated by the exposure beam 40 at a wavelength λ, emitted by a CW or pulsed laser, at which the photosensitive layer 15 (for instance a photoresist layer) is photo-chemically sensitive. The general plane of the light sheet is parallel to the lines of the phase mask grating. The exposure light sheet is incident onto the grating of the phase mask, preferably normally to the plane of the phase mask. It can also have an oblique incidence under an incidence angle corresponding to the -1^{st} order Littrow mounting. These two cases are respectively shown on Figures 2a and 2b. The incident beam is in the form of a divergent plane light sheet of essentially uniform power density along the transverse coordinate Y produced from a Gaussian laser beam by means of a line generating diffractive optical element (DOE) 10. In the Littrow mounting a divergent incident light sheet would slightly alter the rectilinearity of the printed lines of the latent grating in the photoresist layer. This can however be corrected by introducing a predistortion of the lines of the phase mask grating, as explained in the section on the light exposure means.

The large grating writing process is made at an approximately constant velocity determined by the exposure light dose to be delivered to the photosensitive layer 15 per surface unit. The exposure power is temporally modulated in synchronism with the displacement of the latent grating by a period of this latent grating, this displacement being read by the two displacement sensors of scale 7 and readhead 6 (Figure 1) to avoid the washing out of the successive lines printed in the photoresist layer. The yaw detection means provide an error signal real time to the tilt actuator 52 for correcting a possible yaw which otherwise could alter in particular the parallelism between the written grating lines. This defines a control loop or feedback for keeping the orientation of the phase mask during the writing process by compensating a detected yaw of the substrate with a corresponding tilt of the phase mask in the other direction. The displacement measurements along the X axis with nanometer resolution can be performed either by high resolution optical encoders, Reference [5], or interferometers, Reference [6].

The latent grating 8 printed in the photosensitive layer 15 is a latent set of periodic photomodified lines which will be revealed at the end of the writing process by means of a development process. Each line of the latent grating 8 receives the needed light dose in the form of N light shots where N is approximately the number of fringes of the interferogram created by the grating of the phase mask 5. The needed dose can also be delivered in the form of N/m light shots where m is an integer number: 2, 3 or 4 for instance.

In a variant of the installation of the invention, the platform is fixed to the basis and the bridge supporting the phase mask is mobile along the X axis. In this variant, the bridge is associated with guiding means and sensors to control its displacement and to detect a possible yaw of the bridge during such a displacement, in order to compensate such a yaw by the tilt actuator. Thus, it is generally a relative displacement between the substrate and the phase mask which is needed for writing a latent grating in the photosensitive layer deposited on the substrate. The guiding means are associated to the moving part.

### A) Description of the phase mask

In the objective of writing a large grating of high spatial coherence, relevant and critical spatial coherence characteristics of the large area grating 8 under fabrication are implemented in the phase mask 5 illuminated by the transversally constant, temporally modulated illumination means as described above. These characteristics are the straightness of the grating lines, the parallelism between them over the whole width of the long grating 8 along Y, the smoothness and regularity of the line edges and the constancy of the line/space ratio and of the groove depth along Y. These characteristics in the large grating according to the present invention result in particular from the constant light dose received by the photoresist layer 15 on each line of the latent grating 8. The phase mask 5 of the invention executes the most complete "macro-function" in the objective of writing a large area grating of high spatial coherence by continuous photoprinting along a single dimension, here the dimension X.

Different types of phase mask can be used to create the needed writing interferogram : a binary grating 13 etched into a fused quartz substrate or a binary grating etched in a high index layer for a more complete suppression of the 0^{th} transmitted order according to Reference [7]. As shown on Figures 2a and 2b, the incidence conditions of incident beam 61 on the phase mask can be different: the incidence can be normal to the phase mask surface in which case the interferogram is created by the +1^{st} and -1^{st} diffraction orders (62 and 63) assuming that the 0^{th} transmitted order (64) is substantially cancelled; the incidence can also be under the -1^{st} order Littrow condition in which case the interferogram is created by the 0^{th} and -1^{st} transmitted orders (65 and 66).

The phase mask can also be composed of two gratings of different period fabricated on two different substrates or on the same substrate as used in References [8] et [9] where the first grating splits the incident beam into two beams, and the second grating directs the latter onto the exposed substrate with an angle between them which is determined by the two grating periods, the angle between the two beams determining the written period.

The long phase mask grating track having its lines along Y can be fabricated by means of an electron beam pattern generator. However, the maximum length which an electron beam pattern generator can write today is 300 millimetres. It is possible to fabricate long phase masks, in particular longer than 300 millimetres, by the scanning of a small phase mask (e.g. 5x5 mm²) having its lines along the scanning direction without modulation of the exposure beam. A possible technique for the fabrication of the grating track of the long phase mask 5 when the length of the phase mask is beyond the possibilities of an electron beam pattern generator is given hereafter as an example. A long bar of rectangular section having at least one reference flat-polished long side of planarity as good as the line straightness wanted in the final large size grating 8 is set on one of its other long sides on the translation platform 2. Such bar can be obtained by a state of the art polishing technique of large objects associated with interferometric control. This reference surface is oriented to be parallel to the displacement direction X. Such orientation can be made by means of a gauging probe or proximity sensor installed on the fixed part of the translation bench, on the basis 1 or on the bridge 4. The substrate on which the lines of grating 13 of the phase mask 5 will be written is preferably a two-side polished fused quartz substrate with the two other sides rectified. One of the rectified sides is abuted against the reference surface of the bar. The long phase mask 5 is written by means of a smaller size phase mask of a few square millimetre area written by means of an electron beam pattern generator, as used in the state of the art, with its lines parallel to the translation along X. If the straightness of the translation platform 2 upon translation along X can not be guaranteed within a small fraction of one micrometer, the distance between the phase mask 5 and the reference surface is controlled by means of a nanometer resolution proximity sensor and a piezoelectric actuator correcting the straightness by a real time small movement along Y of the small phase mask.

The vertical distance H between the phase mask grating 13 and the surface of the substrate 3 is not critical since the interferogram produced by the phase mask 5 of figure 2a under normal incidence and that of figure 2b under -1^{st} order Littrow incidence is composed of a set of adjacent bright and dark fringe extending in planes parallel to the phase mask grating lines and normal to the surface of the phase mask 5; this is not strictly true in the case of Littrow incidence of a diverging exposure light sheet as it will be explained in the section on the light exposure means hereafter and where predistorsion means are disclosed. The adjustment of normal and Littrow incidence is easily and precisely made by autocollimation. The interference fringes of the interferogram exist up to a distance from the phase mask grating where the + and -1^{st} orders (figure 1a) or the 0^{th} and -1^{st} orders (figure 3b) produced by the finite width phase mask grating 13 have walked off. Beyond this distance the concerned diffraction orders propagate without overlaping, i.e., without interfering. Thus the phase mask grating 13 is placed close enough to the surface of substrate 3 to ensure that the photoresist layer is placed in a plane where there is a substantial overlap between the interfering orders. For instance, assuming a phase mask grating 13 of width 1 mm, and exposure wavelength of 442 nm, a phase mask grating period of 1200 nm (figure 2a) or 600 nm (figure 2b) to give rise to an interferogram, thus a latent grating in the photoresist layer of 600 nm period, a reasonable distance between phase mask grating 13 and the surface of substrate 3 is between 50 and 300 micrometers.

Upon the continuous displacement along X of the platform 2 under the synchronized temporally modulated or pulsed exposure, each line of the latent grating in the photoresist layer received its light dose in the form of a number of exposures approximately equal to the number of fringes in the interferogram, i.e., if the overlap between the interfering orders is close to 100%, approximately 1700 sub-doses in the above example. Each sub-dose is delivered to a given latent grating line by the about 1700 successive bright fringes of the interferogram. It is of paramount importance that each sub-dose is delivered at the same location in the photoresist layer. This is ensured by the synchronism between the continuous platform displacement along X and the modulation rate of the light source and, according to the present invention, by the real time control of the yaw during the displacement. To prevent the spreading of the sub-doses around the assigned position, i.e., to prevent a degradation of the contrast of the latent grating in the photoresist layer, or even a washing out of the latter, the yaw must be kept under a certain limit. This limit is set by requiring that one line of the latent grating "sees" upon its displacement along X each of the 1700 bright fringes of the interferogram with a parallelism better than a small fraction of the interferogram period A all over its length L_{y}. A yaw angle δ of A/L_{y} can cause a substantial washing out of the latent grating. Consequently, according to the present invention, a reasonable maximum limit assigned to the yaw angle is A/(5L_{y}), preferably A/(8L_{y}), where A is the period of the grating under fabrication and L_{y} is the length of the phase mask which approximately corresponds to the width of this grating 8. In the above example, assuming a grating width L_{y} of 1 meter, the maximum tolerated yaw angle δ is about 6E-8. If instead of a 600 nm period grating one considers a 100 nm period grating, it is a yaw angle below 10⁻⁸ which must be ensured. This can not be guaranteed by a translation stage without active control of the yaw and its compensation by a tilt of the phase mask (or of the substrate in a variant not shown), as implemented in the preferred embodiment of the present invention.

According to a particularly interesting feature of the present invention, the length of the phase mask grating 13, corresponding to the width of the large grating 8 under fabrication, is greater than 100 millimetres and in particular greater than 300 millimetres. This length can be as long as the width of large flat displays, e.g. 1094 mm as in the last Sharp LCD LK816D3LA12 of 1094 x 1879 mm area, and even greater in the near future. This example is given because energy saving LCDs use a polarizer in the form of a metal wire grid of period smaller than approximately 150 nanometers.

The longer the grating lines, the more critical the yaw for the spatial coherence of the grating under fabrication and for the contrast of the latent grating and thus for the regularity of some characteristics (in particular the line/space ratio and the depth of the grating lines) of the grating 8. A relative yaw between the substrate under light exposure and the phase mask occurring during a scanning can thus lead to a loss of contrast of the latent grating and can even cause the washing out of the periodic latent grating lines at least at the edges of the latent grating. This loss of contrast is due to the fact that the orientation of the fringes of the temporally modulated interferogram varies during the printing of the lines of the latent grating in the photoresist. It is to be noted that each line of the latent grating receives its needed light dose in the form of a large number of successive light exposures resulting from the temporal modulation of the light.

### B) The light exposure means

The light exposure beam of the long phase mask 5 is a plane light sheet parallel to axis Y having a top hat power profile along Y as illustrated in Figure 3.

The plane light sheet is created from a the circular cross-section collimated Gaussian laser beam at the exposure wavelength (for instance a HeCd laser beam at 442 nm wavelength) by means of a Fourier diffractive optical element 10 (DOE) performing the function of a line generator.

The line generator is preferably a diffractive multilevel optical element (Computer Generated Hologram or CGH) of the state of the art, fabricated by standard multilevel lithography in fused silica. The design technique used is an adapted IFTA algorithm (Iterative Fourier Transform Algorithm), in which has been implemented a simulated annealing process with slow temperature variations over several cycles. Error reinjection can be performed in the DOE plane. An additional speckle reduction algorithm can also be used in order to reduce speckle effects along the line, which consist of phase randomization. Speckle averaging can also be made by inducing a small amplitude dithering of the DOE in its plane along the direction of the plane of the light sheet.

The DOE 10 can not presently have a large angular aperture, i.e., the light sheet emerging from it has a low divergence because the DOE fabrication technologies are not ready yet to provide high diffraction efficiency and large aperture at once. For instance, today's DOE technology permits to obtain a divergence angle of the plane light sheet of about 10 to 15 degrees defined from the optical axis parallel to the X direction. This implies that the light sheet has to diverge over quite a long path to reach a width equal to the length of the phase mask grating 13. For saving space, the plane light sheet can be folded, possibly several times by plane mirror(s) before impinging onto the phase mask. An advantage of a small aperture DOE is that it preserves at the output the polarisation state at its input. The plane light sheet diverges along Y while propagating along X. When it falls onto the phase mask grating after having experienced a reflection on a plane mirror 21 (optional) either under normal incidence or under -1^{st} order Littrow incidence, its electric field E must be oriented along Y (line direction), i.e. the electric field must lie in the light sheet plane so as to ensure a high contrast interferogram 20 under the phase mask which can only be obtained with the so-called TE polarization, i.e. the electric field parallel to the lines of the grating 13 of the phase mask 5. The light sheet needs not be collimated because the symmetry and the period of the interferogram 20 created under the phase mask does not depend on the angle which the incident rays of the light sheet make in the plane normal to the phase mask and parallel to its grating lines. The very divergent character of the exposure plane light sheet permits to illuminate a phase mask of almost arbitrary length, i.e. a large grating of almost arbitrary width, without increase of the cost of the optical exposure system.

The illumination means ensure the following conditions : The divergence of the light sheet incident onto the phase mask grating 13 in the plane normal to the light sheet is very small, for instance it is equal to the typical natural divergence of one milliradian (1 mrad) of a gas laser beam and the stability of the incidence angle in this plane is high, for instance within 0,1 mrad to ensure that the fringes of the phase mask interferogram 20 keep a stable direction during the scan along X and ensure the straightness of the lines of the fabricated grating. On the contrary, the angle of incidence in the general plane of the light sheet, relative to the normal to the phase mask grating lines in this general plane, can be non-zero since the direction of the fringes of the interferogram 20 does not depend on this angle. This is strictly true only in the case of a phase mask on which the light sheet is incident normally to the plane of the phase mask grating where the interferogram results from the interference between the +1^{st} and -1^{st} orders In the case of a phase mask on which a divergent light sheet impinges under the Littrow angle for the -1^{st} order of the phase mask grating, the dark and bright fringes of the interferogram resulting from the interference between the 0^{th} and -1^{st} orders of the phase mask grating are not strictly normal to the plane of the phase mask grating. This means that a Littrow incidence phase mask grating made of strictly straight grating lines prints in the photoresist layer located at a distance H from the phase mask grating a latent grating of slightly curved grating lines in the case of a divergent exposure light sheet. An approximate expression is given for the deviation ΔX(Y) along X of the position of the latent grating lines relative to perfect line straightness versus Y. Let one ray of the exposure light sheet emanating from the DOE and making an angle φ in the light sheet plane with the plane normal to the phase mask plane and containing the axis X. This ray impinges on the phase mask at the ordinate Yᵣ = Ltgφ on axis Y where L is the distance in the light sheet between the DOE and the phase mask center. The angle θ_{L} between the exposure light sheet plane and the plane normal to the phase mask plane and containing the axis Y is the Littrow angle θ_{L} = sin⁻¹(λ/(2Λ)); Λ is the period of the interferogram; it is also the period of the phase mask grating in the case of the phase mask under Littrow incidence. The deviation ΔX(Yᵣ) is given by ΔX(Yᵣ) = Hφ²sin²θ_{L}/(λcosφcosθ_{L}) where φ = tan⁻¹(Yᵣ/L). The lines of the latent grating are very slightly curved, the sign of the curvature being the same as the sign of the curvature of the wave front of the divergent beam. If a strictly straight line latent grating is desired, the phase mask grating must be given an opposite curvature as a pre-distortion.

The illumination means can be of different types :
- A CW or pulsed laser in the blue or UV wavelength range whose beam is transformed into a diverging light sheet of top hat intensity profile by means of a Fourier line generator 10, the electric field polarization being in the plane of the light sheet. There is no particular demand on the temporal coherence of the laser. The use of a large lens or mirror to collimate the diverging light sheet is possible but not needed.
- A linear matrix of semiconductor lasers emitting in the blue range of length equal to the length of the phase mask combined with a linear array of micro-lenses and a beam homogenizer.
- A single CW or pulsed collimated laser beam sweeping the phase mask grating along its whole length along Y by means of a galvanic mirror or any other means, the instantaneous power being adjusted so as to deposit a constant dose.

The power modulation needed is made in a sinusoidal form or in synchronism with the sweeping rate of the grating lines under the phase mask 5. Instead of a sinusoidal modulation, it can be a square signal modulation with needed duty cycle, in order to control the dose in the photoresist layer 15 and thus the final written grating line/space ratio.

In the case of a pulsed laser, pulses are triggered by the displacement information given by the two optical encoders of read head 6 and scale 7 or by two interferometers in synchronism with the written grating period.

### C) The photo-inscription process

The photo-inscription of the interferogram is made in a photoresist layer 15 spread onto the substrate of the future grating followed by a development step to transform the latent grating 8 into a corrugation, and an etching process to transfer the resist corrugation into the hard material of the substrate 3 (Reference [10]). The process can also be a photomodification of the hydrophilic or hydrophobic characteristics of the substrate surface or of any other surface property. It can also be the photopolymerization of a hybrid sol-gel.

The deposition of the photoresist or of other photo-sensitive layers on large substrates can be performed by using several processes. Classical spin coaters for flat and large substrates up to flat display sizes, or dip-coaters and spray coaters for very large substrates and non-flat substrates.

### D) Variants

The disclosed grating writing method is not limited to strictly periodic gratings and to one dimension gratings.

The period of latent grating 8 can be varied by the control of the relative displacement along X within a spatial frequency range which is smaller than the spectral width of the Fourier transform of the grating 13 of finite length of the phase mask 5.

The lines of latent grating 8 can deviate from a strict parallelism by controlling the phase mask orientation upon translation along X for instance by means of the tilt actuator 52.

A two-dimension grating can be fabricated by two successive scans with the same phase mask or with two phase masks of different period and rotating the substrate by 90 degrees.

The disclosed grating writing method can be applied to large surfaces which are not particularly flat and have certain waviness like a drawn or float glass plate because the method is very tolerant on the spacing between the phase mask and the photoresist coated surface. The method can also be applied to the writing of a grating on a thin flexible film pasted on a hard flat substrate which, after separation from the substrate, can later be wrapped and glued on a curved surface such as in an X-ray spectrometer.

### References:

[1] E. Gamet Y. Jourlin, S. Pélissier, R. Min, S. Reynaud, C. Veillas, J.C. Pommier, O. Parriaux, "Flying phase mask for the printing of long submicron-period stitchingless gratings", Microelectronic Engineering, pp. 734-737, Vol. 83 (2006).
[2] S. Henein, "Conception Des Guidages Flexibles", Presses Polytechniques et Universitaire Romandes, Lausanne (2001).
[3] C. Evans, M. Holmesa, F. Demaresta, D. Newtona and A. Steina, "Metrology and Calibration of a Long Travel Stage", Zygo Corporation, Middlefield, CT, USA CIRP Annals - Manufacturing Technology. pp 495-498, Vol. 54 (2005).
[4] R. Thalmann "Calibration of granite squareness standards", 1st International Conference of the European society of Precision Engineering and Nanotechnology -EUSPEN, Bremen, Germany (1999).
[5] Ralf K. Heilmann, Carl G. Chen,. Paul T. Konkola,.Mark L. Schattenburg, "Dimensional metrology for nanometer-scale science and engineering towards sub-nanometer accurate encoders" S504-S511, Nanotechnology 15 (2004).
[6] Frank C. Demarest "High-resolution, high-speed, low data age uncertainty, heterodyne displacement measuring interferometer electronics" Meas. Sci. Technol. vol 7, pp1024-1030 (1998).
[7] E. Gamet, A.V. Tishchenko, O. Parriaux, "Cancellation of the zeroth order in a phase mask by mode interplay in a high index contrast binary grating", Applied Optics, Vol. 46, pp. 6719-6726 (2007).
[8] Anne-Laure Charley, Alexandre Lagrange, Olivier Lartigue, Philippe Bandelier, Marianne Derouard, Patrick Schiavone, "Liquid immersion lithography at 193 nm using a high-NA achromatic interferometer". Proc. of SPIE Vol. 6154 (2006).
[9] Anthony Yen, Erik H. Anderson, R. A. Ghanbari, M. L. Schattenburg, and Henry Smith, "Achromatic holographic configuration for 100-nm-period lithography" Applied Optics, Vol. 31, No. 22, 4540 (1992).
[10] T. Hänsel, F. Frost, A. Nickel, A. Schindler. "Ultra-precision Surface Finishing by Ion Beam Techniques" Vakuum in Forschung und Praxis 19 Nr. 5 24-30 (2007).

## Claims

1. Installation for writing gratings comprising :
- a basis (1),
- a platform (2) arranged for receiving a substrate (3) covered by a photosensitive layer (15),
- a phase mask (5) having lines defining at least a grating, this phase mask being supported by a bridge (4),
- a light source associated with means (10) for projecting an exposure beam (40) on said phase mask which diffracts said exposure beam to form an interferogram in said photosensitive layer so as to define in this photosensitive layer a latent grating (8) having a determined period Λ;
wherein said platform and said bridge are mounted on said basis so that a relative translation movement can occur between them, said platform or said bridge defining a moving part (2) associated with guiding means along a translation axis (X);
**characterized in that** said phase mask has a length L_{Y}, along an orthogonal axis (Y) relative to said translation axis (X), which is greater than hundred millimetres (100 mm), the lines of this phase mask being parallel to said orthogonal axis, **in that** this installation comprises sensor means (6, 7) for detecting, during said relative translation movement, a possible yaw between said phase mask and said substrate and further comprises a tilt actuator (52) controlled in function of the detection of said possible yaw and arranged for varying the orientation of said phase mask (5) relatively to said substrate (3) in order to limit said possible yaw under a maximum value equal to Λ(5L_{Y}), and **in that** said exposure beam is formed by a light sheet having its general plane parallel to the lines of said phase mask.

2. Installation according to claim 1, wherein said tilt actuator is mounted on said bridge (4) and arranged so as to rotate a frame of the phase mask relative to said bridge in order to slightly vary its orientation relative to this bridge.

3. Installation according to claim 1 or 2, wherein said sensor means are formed by two displacement sensors each comprising a grating scale (7) fixed to said basis (1) and a read head (6) fixed to said moving part (2).

4. Installation according to any one of the preceding claims, wherein said light sheet is divergent in its general plane and substantially collimated in a direction normal to this general plane.

5. Installation according to any one of the preceding claims, wherein said length L_{Y} of said phase mask (5) is superior to three hundred millimetres (300 mm).

6. Installation according to any one of the preceding claims, wherein said tilt actuator is controlled for limiting said possible yaw under a maximum value equal to Λ/(8L_{Y}).

7. Installation according to any of the preceding claims, wherein said relative translation movement is defined by a continuous displacement of said moving part (2) and said light source has its power temporally modulated in synchronism with the displacement of said latent grating (8) by a period of this latent grating.

8. Installation according to any of the preceding claims, wherein the polarization of the electric field of the light sheet is parallel to its general plane.

9. Installation according to claim 4, wherein the divergence of the light sheet normally to its general plane is smaller than one milliradian (1 mrad).

10. Installation according to any of the preceding claims, wherein the means for projecting said light sheet is a multilevel diffractive optical element.

11. Installation according to claim 10, wherein the diffractive optical element has a dithering along said orthogonal axis (Y) to average the speckle in the photosensitive layer.

12. Installation according to any of claims 1 to 9, wherein the means for projecting said light sheet is an array of semiconductor lasers.

13. Installation according to any of claims 1 to 9, wherein the means for projecting a light sheet is a moving mirror sweeping a temporally modulated collimated laser beam along the phase mask.

14. Installation according to any of the preceding claims, wherein it is arranged so that the generated latent grating has a variable period within the spectral width of the Fourier transform of the phase mask grating.

15. Installation according to any of the preceding claims, wherein it is arranged so that the lines of the latent grating deviate from a strict parallelism by controlling the phase mask orientation upon said relative translation movement.

## Patentansprüche

1. Anlage zum Schreiben von Beugungsgittern, die umfasst:
- eine Basis (1),
- eine Plattform (2), die dafür ausgelegt ist, ein Substrat (3), das mit einer lichtempfindlichen Schicht (15) beschichtet ist, aufzunehmen,
- eine Phasenmaske (5), die Linien besitzt, die wenigstens ein Beugungsgitter definieren, wobei diese Phasenmaske von einer Brücke (4) getragen wird,
- eine Lichtquelle, der Mittel (10) zugeordnet sind, um einen Belichtungsstrahl (40) auf die Phasenmaske zu projizieren, die den Belichtungsstrahl beugt, um in der lichtempfindlichen Schicht ein Interferogramm zu bilden, um so in dieser lichtempfindlichen Schicht ein latentes Beugungsgitter (8) mit einer bestimmten Periode A zu definieren;
wobei die Plattform und die Brücke an der Basis in der Weise montiert sind, dass eine relative translatorische Bewegung zwischen ihnen erfolgen kann, wobei die Plattform oder die Brücke einen beweglichen Teil (2) definieren, dem Führungsmittel längs einer Translationsachse (X) zugeordnet sind;
**dadurch gekennzeichnet, dass** die Phasenmaske eine Länge L_{Y} längs einer in Bezug auf die Translationsachse (X) orthogonalen Achse (Y) besitzt, die größer als hundert Millimeter (100 mm) ist, wobei die Linien dieser Phasenmaske zu der orthogonalen Achse parallel sind, dass diese Anlage Sensormittel (6, 7) umfasst, um während der relativen Translationsbewegung eine mögliche Gierbewegung zwischen der Phasenmaske und dem Substrat zu detektieren, und ferner einen Neigungsaktor (52) umfasst, der als Funktion der Detektion der möglichen Gierbewegung gesteuert wird und dafür ausgelegt ist, die Orientierung der Phasenmaske (5) relativ zu dem Substrat (3) zu variieren, um die mögliche Gierbewegung unter einem Maximalwert, der gleich Λ/(5L_{Y}) ist, zu halten, und dass der Belichtungsstrahl durch eine Lichtplatte gebildet wird, deren allgemeine Ebene zu den Linien der Phasenmaske parallel ist.

2. Anlage nach Anspruch 1, wobei der Neigungsaktor an der Brücke (4) montiert ist und so beschaffen ist, dass er einen Rahmen der Phasenmaske relativ zu der Brücke dreht, um deren Orientierung relativ zu der Brücke geringfügig zu variieren.

3. Anlage nach Anspruch 1 oder 2, wobei die Sensormittel durch zwei Verlagerungssensoren gebildet sind, wovon jeder eine Beugungsgitterskala (7), die an der Basis (1) befestigt ist, und einen Lesekopf (6), der an dem Bewegungsteil (2) befestigt ist, umfasst.

4. Anlage nach einem der vorhergehenden Ansprüche, wobei die Lichtplatte in ihrer allgemeinen Ebene divergent ist und in einer Richtung senkrecht zu dieser allgemeinen Ebene im Wesentlichen parallel orientiert ist.

5. Anlage nach einem der vorhergehenden Ansprüche, wobei die Länge (L_{Y}) der Phasenmaske (5) größer als dreihundert Millimeter (300 mm) ist.

6. Anlage nach einem der vorhergehenden Ansprüche, wobei der Neigungsaktor gesteuert wird, um die mögliche Gierbewegung unter einem Maximalwert, der gleich Λ/(8L_{Y}) ist, zu halten.

7. Anlage nach einem der vorhergehenden Ansprüche, wobei die relative Translationsbewegung durch eine ununterbrochene Verlagerung des Bewegungsteils (2) definiert ist und die Leistung der Lichtquelle vorübergehend synchron mit der Verlagerung des latenten Beugungsgitters (8) mit einer Periode dieses latenten Beugungsgitters moduliert wird.

8. Anlage nach einem der vorhergehenden Ansprüche, wobei die Polarisation des elektrischen Feldes der Lichtplatte zu deren allgemeiner Ebene parallel ist.

9. Anlage nach Anspruch 4, wobei die Divergenz der Lichtplatte senkrecht zu ihrer allgemeinen Ebene kleiner als ein Milliradian (1 mrad) ist.

10. Anlage nach einem der vorhergehenden Ansprüche, wobei die Mittel zum Projizieren der Lichtplatte ein optisches Beugungselement mit mehreren Ebenen sind.

11. Anlage nach Anspruch 10, wobei das optische Beugungselement längs der orthogonalen Achse (Y) ein Dithering aufweist, um das Fleckenrauschen in der lichtempfindlichen Schicht zu mitteln.

12. Anlage nach einem der Ansprüche 1 bis 9, wobei die Mittel zum Projizieren der Lichtplatte eine Anordnung von Halbleiterlasern sind.

13. Anlage nach einem der Ansprüche 1 bis 9, wobei die Mittel zum Projizieren einer Lichtplatte ein beweglicher Spiegel sind, der einen temporär modulierten kollimierten Laserstrahl längs der Phasenmaske ablenkt.

14. Anlage nach einem der vorhergehenden Ansprüche, die so beschaffen ist, dass das erzeugte latente Beugungsgitter eine variable Periode innerhalb der Spektralbreite der Fourier-Transformation des Phasenmasken-Beugungsgitter besitzt.

15. Anlage nach einem der vorhergehenden Ansprüche, die so beschaffen ist, dass die Linien des latenten Beugungsgitters von einer strikten Parallelität abweichen, indem die Phasenmaskenorientierung bei der relativen Translationsbewegung gesteuert wird.

## Revendications

1. Installation pour l'écriture de réseaux comprenant :
- une base (1),
- une plateforme (2) agencée pour recevoir un substrat (3) recouvert d'une couche photosensible (15),
- un masque de phase (5) dont les lignes définissent au moins un réseau, ce masque de phase étant supporté par un pont (4),
- une source de lumière associée à des moyens (10) de projection d'un faisceau d'exposition (40) sur le dit masque de phase qui diffracte le dit faisceau d'exposition pour former un interférogramme dans la dite couche photosensible de façon à définir dans cette couche photosensible un réseau latent (8) ayant une période déterminée A;
dans laquelle la dite plateforme et le dit pont sont montés sur la dite base de façon à ce qu'un mouvement relatif de translation peut se produire entre eux, la dite plateforme ou le dit pont définissant une partie mobile (2) associée à des moyens de guidage le long d'un axe de translation (X) ;
**caractérisée en ce que** le dit masque de phase a une longueur L_{Y}, le long d'un axe (Y) orthogonal au dit axe de translation (X), qui est plus grande que cent millimètres (100 mm), les lignes de ce masque de phase étant parallèles au dit axe orthogonal, **en ce que** cette installation comprend des moyens de mesure (6,7) pour détecter, pendant le dit mouvement relatif de translation, un possible lacet entre le dit masque de phase et le dit substrat et comprend de plus un actuateur d'orientation (52) contrôlé en fonction de la détection du dit possible lacet et agencé pour varier l'orientation du dit masque de phase (5) relativement au dit substrat (3) de façon à limiter le dit possible lacet en dessous d'une valeur maximale égale à (Λ/(5L_{Y}), et **en ce que** le dit faisceau d'exposition a la forme d'une feuille de lumière ayant son plan général parallèle aux lignes du dit masque de phase.

2. Installation selon la revendication 1, dans laquelle le dit actuateur d'orientation est monté sur le dit pont (4) et agencé de façon à tourner un cadre du masque de phase relativement au dit pont pour varier quelque peu son orientation relativement à ce pont.

3. Installation selon la revendication 1 ou 2, dans laquelle les dits moyens de mesure sont formés de deux capteurs de déplacement, chacun comprenant une règle de réseau (7) fixée à la dite base (1) and une tête de lecture (6) fixée à la dite partie mobile (2).

4. Installation selon l'une quelconque des précédentes revendications, dans laquelle la dite feuille de lumière est divergente dans son plan général et essentiellement collimatée dans une direction normale à ce plan général.

5. Installation selon l'une quelconque des précédentes revendications, dans laquelle la dite longueur L_{Y} du dit masque de phase (5) est supérieure à trois cent millimètres (300 mm).

6. Installation selon l'une quelconque des précédentes revendications, dans laquelle le dit actuateur d'orientation est contrôlé pour limiter le dit possible lacet en dessous d'une valeur maximale égale à Λ/(8L_{Y}).

7. Installation selon l'une quelconque des précédentes revendications, dans laquelle le dit mouvement relatif de translation est défini par un déplacement continu de la dite partie mobile (2) et la dite source de lumière a sa puissance modulée temporellement en synchronisme avec le déplacement du dit réseau latent (8) à la période de ce réseau latent.

8. Installation selon l'une quelconque des précédentes revendications, dans laquelle la polarisation du champ électrique de la feuille de lumière est parallèle à son plan général.

9. Installation selon la revendication 4, dans laquelle la divergence de la feuille de lumière normalement à son plan général est plus petite qu'un milliradian (1 mrad).

10. Installation selon l'une quelconque des précédentes revendications, dans laquelle les moyens de projection de la dite feuille de lumière est un élément optique diffractant multiniveau.

11. Installation selon la revendication 10, dans laquelle l'élément optique diffractant oscille le long du dit axe orthogonal (Y) pour moyenner le « speckle » dans la couche photosensible.

12. Installation selon l'une quelconque des revendications 1 à 9, dans laquelle les moyens de projection de la feuille de lumière consistent en une barrette de laser à semi-conducteur.

13. Installation selon l'une quelconque des revendications 1 à 9, dans laquelle les moyens de projection de la feuille de lumière consistent en un miroir mobile balayant un faisceau laser collimaté modulé temporellement le long du masque de phase.

14. Installation selon l'une quelconque des précédentes revendications, laquelle est agencée de façon à ce que le réseau latent généré a une période variable à l'intérieur de la largeur spectrale de la transformée de Fourier du réseau du masque de phase.

15. Installation selon l'une quelconque des précédentes revendications, laquelle est agencée de façon à ce que les lignes du réseau latent diffèrent d'un strict parallélisme par le contrôle de l'orientation du masque de phase lors du dit mouvement relatif de translation.
